# EUROPÄISCHE PATENTSCHRIFT

(11) **EP 2 678 912 B1**
(45) Veröffentlichungstag und Bekanntmachung des Hinweises auf die Patenterteilung: **03.12.2014**
(21) Anmeldenummer: 12710161.6
(22) Anmeldetag: 21.02.2012
(51) Int. Cl.: H02H 9/04, G01R 31/327, G01R 31/28

(54) **ÜBERSPANNUNGSSCHUTZSCHALTUNG UND VERFAHREN ZUR ÜBERPRÜFUNG EINER ÜBERSPANNUNGSSCHUTZSCHALTUNG**
SURGE PROTECTION CIRCUIT AND METHOD FOR TESTING A SURGE PROTECTION CIRCUIT
CIRCUIT DE PROTECTION CONTRE LES SURTENSIONS ET PROCÉDÉ DE SURVEILLANCE D'UN CIRCUIT DE PROTECTION CONTRE LES SURTENSIONS

(30) Priorität: 24.02.2011 DE 102011012284
(43) Veröffentlichungstag der Anmeldung: 01.01.2014
(73) Patentinhaber: KNORR-BREMSE Systeme für Nutzfahrzeuge GmbH, 80809 München (DE)
(72) Erfinder: FEUCHT, Thomas, 71299 Wilmsheim (DE)
(86) Internationale Anmeldenummer: PCT/EP2012/052896
(87) Internationale Veröffentlichungsnummer: WO 2012/113769

(56) Entgegenhaltungen:
- EP-A2- 2 071 690
- DE-A1-102006 034 780
- US-A1- 2006 198 075

## Beschreibung

Die vorliegende Erfindung bezieht sich auf eine Überspannungsschutzschaltung sowie ein Verfahren zur Überprüfung einer Überspannungsschutzschaltung gemäß den Hauptansprüchen.

In herkömmlichen elektronischen Schaltungen wie beispielsweise einem Steuergerät für Sicherheitsmittel in Nutzfahrzeugen, wird oftmals eine Schutzschaltung zur Vermeidung von zu hohen Spannungen auf Anschlüssen von integrierten Schaltungen eingesetzt. Dabei kann meist nicht überprüft werden, ob diese Schutzschaltung im Laufe der Zeit noch funktionsfähig ist oder bereits durch Korrosion oder andere Umwelteinflüsse ihre Funktion verloren hat. Ist die Schutzschaltung nicht mehr funktionsfähig, kann dies im Stand der Technik nicht verifiziert werden und es besteht nur noch ein vermeintlicher Schutz gegen solche zu hohen Spannungen auf Anschlüssen der integrierten Schaltung. Dies bedeutet, dass bei einem tatsächlichen Auftreten von zu hohen Spannungen auf Anschlüssen von integrierten Schaltungen die Schutzfunktion dieser Schutzschaltung nicht mehr gewährleistet ist, so dass in diesem Fall trotz des Vorsehens der Schutzschaltung die integrierte Schaltung möglicherweise beschädigt wird.

Die DE 10 2006 034780 A1 offenbart eine Energieversorgungs-Schutzschaltung für eine elektronische Vorrichtung innerhalb eines Fahrzeugs.

Die US 2006/198075 A1 offenbart einen Blitzschutzschaltkreis und eine Radiofrequenz-Signalverarbeitungseinheit, das einen solchen Blitzschutzschaltkreis aufweist.

Die EP 2 071 690 A2 offenbart eine Überspannungsschutzschaltung und elektronische Vorrichtung damit.

Es ist die Aufgabe der vorliegenden Erfindung eine verbesserte Überspannungsschutzschaltung sowie ein verbessertes Verfahren zur Überprüfung einer Überspannungsschutzschaltung zu schaffen, die einen kostengünstigen und testbaren Überspannungsschutz, beispielswiese zum Einsatz in Steuergeräten, zu schaffen.

Diese Aufgabe wird durch eine Überspannungsschutzschaltung sowie ein Verfahren gemäß den Hauptansprüchen gelöst.

Die vorliegende Erfindung schafft eine Überspannungsschutzschaltung mit folgenden Merkmalen:
- zumindest einem ersten elektronischen Bauelement mit einer nichtlinearen Kennlinie, das elektrisch leitfähig zwischen einen mit einem Versorgungspotential beaufschlagbaren Abgriffspunkt und einem Knotenpunkt geschaltet ist;
- zumindest einem zweiten elektronischen Bauelement mit einer nichtlinearen Kennlinie, das elektrisch leitfähig zwischen einen mit einem Massepotenzial beaufschlagbaren Abgriffspunkt und dem Knotenpunkt geschaltet ist;
- einem Widerstand, der zwischen dem Knotenpunkt und einem Steueranschluss geschaltet ist; und
- einer Überwachungseinheit, die ausgebildet ist, um an dem Steueranschluss eine vorbestimmte Spannung anzulegen oder über den Steueranschluss einen vorbestimmten Strom auszugeben und hierauf ansprechend eine Spannung oder ein Potenzial an dem Knotenpunkt zu erfassen, wobei die Überwachungseinheit (230) ausgebildet ist, um eine Fehlfunktion der Überspannungsschutzschaltung zu erkennen, wenn die erfasste Spannung oder das erfasste Potenzial nicht in einer vorbestimmten Beziehung zu einer erwarteten Spannung oder einem erfassten Potenzial steht.

Ferner schafft die vorliegende Erfindung ein Verfahren zur Überprüfung einer Überspannungsschutzschaltung gemäß einem der vorangegangenen Ansprüche, wobei das Verfahren die folgenden Schritte umfasst:
- Beaufschlagen des Steueranschlusses mit einer vorbestimmten Spannung oder Einprägen eines vorbestimmten Stroms in den Steueranschluss;
- Erfassen einer Spannung oder eines Potenzials an dem Knotenpunkt; und
- Erkennen einer Fehlfunktion der Überspannungsschutzschaltung, wenn die erfasste Spannung oder das erfasste Potenzial an dem Knotenpunkt nicht in einer vorbestimmten Beziehung zu einer erwarteten Spannung oder einem erwarteten Potenzial steht.

Von Vorteil ist auch ein Computerprogrammprodukt mit Programmcode, der auf einem maschinenlesbaren Träger wie einem Halbleiterspeicher, einem Festplattenspeicher oder einem optischen Speicher gespeichert sein kann und zur Durchführung des Verfahrens nach einer der vorstehend beschriebenen Ausführungsformen verwendet wird, wenn das Programm auf einem Signalverarbeitungssystem wie einem Computer oder einem entsprechenden Gerät ausgeführt wird.

Die vorliegende Erfindung basiert auf der Erkenntnis, dass nun ein Überspannungsschutz durch die Verwendung von zwei in Serie geschalteten elektronischen Bauelementen realisiert werden kann, bei denen ein Knotenpunkt zwischen diesen beiden Bauelementen zum Abgriff oder zur Einprägung einer Spannung zugänglich ist. Über diesen Knotenpunkt kann einerseits mittels eines Widerstands eine entsprechende Spannung oder ein entsprechender Stromfluss von einem Steueranschluss eingeprägt werden, worauf die Reaktion des ersten und/oder zweiten elektronischen Bauelements überprüft werden kann, wobei das erste und zweite Bauelement mit dem Massepotenzial oder dem Versorgungspotenzial verbunden sind. Auf diese Weise kann sowohl die Funktion des ersten als auch des zweiten Bauelements überwacht werden, beispielsweise wenn eine Abweichung von einer erwarteten Spannungen gegenüber einer ermittelten Spannung am Knotenpunkt (jeweils bezogen auf das Massepotenzial) auftritt, wenn die vorbestimmte Spannung am Steueranschluss angelegt wurde oder wenn der vorbestimmte Strom in den Steueranschluss eingeprägt wurde. Eine solche Überwachung ermöglicht nun vorteilhaft gegenüber dem Stand der Technik, bei dem lediglich ein Bauelement zwischen einen ersten Anschluss, der mit einem Versorgungspotenzial beaufschlagt werden kann und einem zweiten Anschluss, der mit einem Massepotenzial beaufschlagt werden kann, die Überprüfung der einzelnen Bauelemente, aus denen sich die Schutzschaltung für ein eines weiteren elektronischen Bauelements (wie beispielsweise einer integrierten Schaltung) zusammensetzt. Die Verwendung von nichtlinearen elektronischen Bauelementen ermöglicht dabei wirksam die Realisierung der Schutzfunktion gegen zu hohe Spannungen. Nichtlineare elektronische Bauelemente sind dabei insbesondere elektronische Bauelemente, die eine nichtlineare Kennlinie dieser Bauelemente in einem Spannung-Strom-Diagramm aufweisen. In Frage kommen hierbei insbesondere elektronische Bauelemente wie Dioden, Zener-Dioden, Transistoren, Thyristoren oder ähnliche Bauelemente, die eine nicht-lineare Kennlinie in einem Spannung-Strom-Diagramm aufweisen. Die Überwachungseinheit kann dabei selbst Teil der vor zu hohen Spannungen zu schützenden integrierten Schaltung, wie beispielsweise ein Mikrocontroller, ein digitaler Signalprozessor oder ähnliches sein.

Günstig ist es, wenn gemäß einer Ausführungsform der vorliegenden Erfindung das erste elektronische Bauelement eine Diode ist, insbesondere wenn deren Kathode mit dem mit dem Versorgungspotential beaufschlagbaren Abgriffspunkt und deren Anode mit dem Knotenpunkt verbunden ist. Eine derartige Ausführungsform der vorliegenden Erfindung bietet den Vorteil einer sehr einfachen Ausgestaltung des ersten elektronischen Bauelements, so dass sich eine kostengünstige Überspannungsschutzschaltung realisieren lässt.

Besonders vorteilhaft ist es, wenn die Diode eine Zener-Diode ist. Eine derartige Ausführungsform der vorliegenden Erfindung bietet den Vorteil einer einfachen Ausgestaltung des ersten elektronischen Bauelements, wobei bei einem tatsächlichen Auftreten von zu hohen Spannungen zwischen dem Versorgungspotenzialanschluss und dem Massepotenzialanschluss das erste Bauelement nicht zerstört wird. Vielmehr kann über eine solche Zener-Diode eine definierte Ableitung der zu hohen Spannungen realisiert werden, wobei die Durchbruchspannung der Zener-Diode einen großen Spannungsabfall der Spannung zwischen dem Versorgungspotenzialanschluss und dem Massepotenzialanschluss ermöglicht.

Ferner kann gemäß einer weiteren Ausführungsform der vorliegenden Erfindung das zweite elektronische Bauelement eine Diode sein. Eine derartige Ausführungsform der vorliegenden Erfindung bietet ebenfalls den Vorteil einer sehr einfachen Ausgestaltung des zweiten elektronischen Bauelements, so dass sich eine kostengünstige Überspannungsschutzschaltung realisieren lässt.

Günstig ist es ferner, wenn diese Diode des zweiten elektronischen Bauelements mit der Anode mit dem Knotenpunkt und deren Kathode mit dem mit dem Massepotenzial beaufschlagbaren Abgriffspunkt verbunden ist. Eine derartige Ausführungsform der vorliegenden Erfindung stellt sicher, dass das zweite elektronische Bauelement eine definierte Ableitung von Strom bei zu hohen Spannungen zwischen dem Versorgungspotenzialanschluss und dem Massepotenzialanschluss vom Knotenpunkt zu dem Massepotenzialanschluss, das heißt dem mit dem Massepotenzial beaufschlagbaren Abgriffspunkt, sicherstellt.

Um eine definierte Spannung einzustellen, ab der Überspannungsschutzschaltung eine Ableitung von Strom unter Umgehung der zu schützenden integrierten Schaltung durchführt, kann ferner zumindest ein drittes elektronisches Bauelement mit einer nichtlinearen Kennlinie vorgesehen sein, wobei das dritte elektronische Bauelement elektrisch leitfähig zwischen das zweite elektronische Bauelement und den mit dem Massepotenzial beaufschlagbaren Abgriffspunkt geschaltet ist, insbesondere wobei das dritte elektronische Bauelement eine Diode ist, deren Anode mit dem zweiten elektronischen Bauelement und deren Kathode mit dem mit dem Massepotenzial beaufschlagbaren Abgriffspunkt verbunden ist. Eine derartige Ausführungsform der vorliegenden Erfindung bietet den Vorteil, dass durch die Serienschaltung des zweiten elektronischen Bauelements und des dritten elektronischen Bauelements eine Summation der an dem zweiten und dem dritten elektronischen Bauelement abfallenden Spannung erreicht werden kann, so dass bei kleinen Durchbruchsspannungen des zweiten und des dritten elektronische Bauelements dennoch eine insgesamt höhere Durchbruchsspannung zwischen Knotenpunkt und dem mit dem Massepotenzial beaufschlagbaren Abgriffspunkt realisierbar ist. Dies ermöglicht eine präzisere Erkennung von Fehlern der Überspannungsschutzschaltung als wenn lediglich eine kleine Spannung zwischen dem Knotenpunkt und dem mit dem Massepotenzial beaufschlagbaren Abgriffspunkt ausgewertet werden müsste.

Alternativ kann auch als zweites elektronisches Bauelement eine Diode verwendet werden, die eine Zener-Diode ist, insbesondere wobei die Kathode der Zener-Diode mit dem Knotenpunkt und die Anode der Zener-Diode mit dem mit dem Massepotenzial beaufschlagbaren Abgriffspunkt verbunden ist. Eine derartige Ausführungsform der vorliegenden Erfindung bietet den Vorteil einer höheren Durchbruchsspannung als bei der Verwendung von einer oder mehreren in Serie geschalteten Dioden als zweites elektronisches Bauelement. Hierdurch lässt sich die Durchbruchsspannung zwischen dem Knotenpunkt und dem mit dem Massepotenzial beaufschlagbaren Abgriffspunkt mit einem einzigen elektronischen Bauelement realisieren, wodurch die Überspannungsschutzschaltung kostengünstig und einfach ausgestaltet werden kann.

Gemäß einer weiteren Ausführungsform der vorliegenden Erfindung ist eine Verwendung einer Überspannungsschutzschaltung gemäß der obigen Beschreibung und/oder eines Verfahrens gemäß der obigen Beschreibung in einem Nutzfahrzeug, insbesondere zum Einsatz in einem Sicherheitsmittelsteuergerät, insbesondere zum Einsatz in einem ABS-Steuergerät vorgesehen. Eine derartige Ausführungsform der vorliegenden Erfindung stellt die korrekte Betriebsweise des Nutzfahrzeugs oder die Funktionsfähigkeit eines solchen Sicherheitsmittelsteuergeräts in einem Nutzfahrzeug wie beispielsweise einem Lkw oder einem Omnibus über einen sehr langen Zeitraum sicher, da beispielsweise in bestimmten Zeitabständen die Funktion des ersten und/oder zweiten elektronischen Bauelements überprüft und gegebenenfalls eine Fehlerwarnung ausgegeben werden kann. Ein defektes Bauelement kann auf diese Weise rechtzeitig erkannt und ausgewechselt werden. Hierdurch lässt sich ein hoher Insassenschutz oder ein Schutz von weiteren Verkehrsteilnehmern kostengünstig erreichen.

Vorteilhafte Ausführungsbeispiele der vorliegenden Erfindung werden nachfolgend Bezug nehmend auf die beiliegenden Zeichnungen näher erläutert. Es zeigen:
- Fig. 1: ein Blockschaltbild eines Nutzfahrzeugs, das ein Ausführungsbeispiel der erfindungsgemäßen Überspannungsschutzschaltung aufweist; und
- Fig. 2: ein Schaltungsdiagramm eines ersten Ausführungsbeispiels der erfindungsgemäßen Überspannungsschutzschaltung;
- Fig. 3: ein Schaltungsdiagramm eines zweiten Ausführungsbeispiels der erfindungsgemäßen Überspannungsschutzschaltung; und
- Fig. 4: ein Ablaufdiagramm eines Ausführungsbeispiels des erfindungsgemäßen Verfahrens.

In der nachfolgenden Beschreibung der bevorzugten Ausführungsbeispiele der vorliegenden Erfindung werden für die in den verschiedenen Zeichnungen dargestellten und ähnlich wirkenden Elemente gleiche oder ähnliche Bezugszeichen verwendet, wobei eine wiederholte Beschreibung dieser Elemente weggelassen wird.

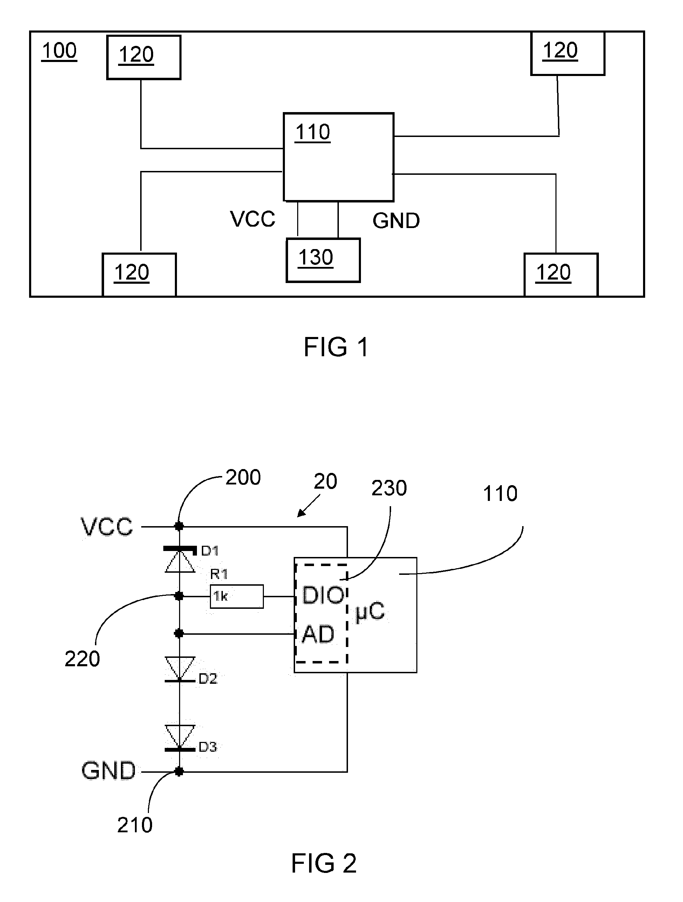

Fig. 1 zeigt ein Blockschaltbild eines Nutzfahrzeugs, das ein Ausführungsbeispiel der erfindungsgemäßen Überspannungsschutzschaltung aufweist. Fig. 1 zeigt ein Nutzfahrzeug 100, beispielsweise einen LKW oder einen Omnibus, welches ein Steuergerät 110 für die ABS-Funktion aufweist, um die Bremseinheiten 120 der Räder des Nutzfahrzeugs 100 mit entsprechenden Steuersignalen zu versorgen. Dabei wird das Steuergerät 110 beispielsweise von einem Energiespeicher 130 (wie beispielsweise einer Batterie) mit elektrischer Energie versorgt, wobei diese elektrische Leistung zwischen einem Versorgungspotenzialanschluss VCC und einem Massepotenzialanschluss GND geliefert wird. Dabei sind auch weitere, in Fig. 1 nicht dargestellte Komponenten mit dem Versorgungspotenzialanschluss VCC und dem Massepotenzialanschluss GND verbunden. Beispielsweise kann eine Ladebuchse zur Ladung des Energiespeichers 130 vorgesehen sein, über den die beiden genannten Potenzialanschlüsse elektrisch kontaktierbar sind.

Wird nun beispielsweise die Ladung des Energiespeichers 130 mit einer zu hohen Spannung durchgeführt, wird auch das Steuergerät 110 mit dieser zu hohen Spannung beaufschlagt, so dass elektronische Komponenten des Steuergerät 110 beschädigt werden könnten. Um eine solche Beschädigung zu vermeiden, wird im Stand der Technik eine Überspannungsschutzschaltung vorgesehen, die beispielsweise darin besteht, dass zwischen dem Versorgungspotenzialanschluss VCC und dem Massepotenzialanschluss GND eine Zener-Diode entgegen der Flussrichtung verbaut wird, bei der bei einem Anliegen einer zu hohen Spannung zwischen dem Versorgungspotenzialanschluss und dem Massepotenzialanschluss eine Durchbruchsspannung überschritten wird. In diesem Fall erfolgt somit eine Ableitung von Strom in Form eines Bypasses um spannungsempfindliche Komponenten des Steuergerät 110 herum, wodurch sich die Spannung zwischen dem Versorgungspotenzialanschluss unter dem Massepotenzialanschluss auf den maximalen bzw. gewünschten Wert senken lässt.

Ist nun jedoch dieses elektronische Bauelement (wie beispielsweise die Zener-Diode) zur Sicherstellung der Schutzfunktion defekt, kann dieser Defekt im Stand der Technik nicht detektiert werden, so dass beispielsweise die Schutzfunktion nicht mehr aktiv ist, auch wenn das elektronische Bauelement zur Sicherstellung der gewünschten Schutzfunktion vorhanden ist. Ein solcher Defekt kann beispielsweise durch Alterung dieses elektronischen Bauelements oder einen Fall des tatsächlichen Auftretens einer zu hohen Spannung zwischen dem Versorgungspotenzialanschluss und dem Massepotenzialanschluss bedient sein.

Um nun einen solchen Fall des Auftretens eines Defektes in einem elektronischen Bauelement zu erkennen, welches die gewünschte Schutzfunktion gegen zu hohe Spannungen zwischen dem Anschluss für das Versorgungsspotenzial VCC und dem Anschluss für das Massepotenzial GND sicherstellt, wird nun gemäß einem ersten Ausführungsbeispiel der vorliegenden Erfindung vorgeschlagenen, zwei elektronische Bauelemente zu verwenden, zwischen denen ein Knoten- oder Abgriffspunkt zugänglich ist, an dem Signale angelegt oder abgegriffen werden können. Ein Schaltungsdiagramm dieses ersten Ausführungsbeispiels der vorliegenden Erfindung ist in der Fig. 2 dargestellt. Durch diese Möglichkeit, Signale zwischen den beiden elektronischen Bauelementen abzugreifen, die die gewünschte Schutzfunktion gegen zu hohe Spannungen zwischen dem Anschluss für das Versorgungspotenzial VCC und dem Anschluss für das Massepotenzial GND sicherstellen, lassen sich nun beide elektronischen Bauelemente auf korrekte Funktionsfähigkeit überprüfen.

Gemäß dem in Fig. 2 dargestellten Schaltungsdiagramm des ersten Ausführungsbeispiels der erfindungsgemäßen Überspannungsschutzschaltung 20 ist zwischen dem mit dem Versorgungsspannungspotenzial VCC beaufschlagbaren Abgriffspunkt 200 und dem mit dem Massepotenzial GND beaufschlagbaren Abgriffspunkt 210 eine Zener-Diode D1 sowie eine erste Diode D2 und eine zweite Diode D3 in Serie geschaltet. Zwischen der Zener-Diode D1 und der ersten Diode D2 ist ein Knotenpunkt 220 angeordnet, der über einen Widerstand R1 mit einem ersten Ausgang DIO (DIO = Digital Input/Output = digitaler Eingang/Ausgang) einer Überwachungseinheit 230 verbunden ist, wobei dieser erste Ausgang DIO als Steueranschluss für die nachfolgende Überwachung der Überspannungsschutzschaltung dient. Die Zener-Diode D1 ist dabei derart verschaltet, dass ihre Anode mit dem Knotenpunkt 220 verbunden ist, während ihre Kathode mit dem mit dem Versorgungspotenzial beaufschlagbaren Abgriffspunkt 200 verbunden ist. Die Anode der ersten Diode D2 ist mit dem Knotenpunkt 220 verbunden, wogegen die Kathode der ersten Diode D2 mit der Anode der zweiten Diode D3 und die Kathode der zweiten Diode D3 mit dem mit dem Massepotenzial GND beaufschlagbaren Abgriffspunkt 210 verbunden ist. Die Überwachungseinheit 230 ist dabei ebenfalls mit dem Versorgungspotenzial VCC beaufschlagbaren Abgriffspunkt 200 sowie dem mit dem Massepotenzial GND beaufschlagbaren Abgriffspunkt 210 verbunden und kann ferner auch noch weitere Komponenten des Steuergeräts wie integrierte Schaltungen eines Mikrocontroller µC enthalten, um beispielsweise die ABS-Funktion des Nutzfahrzeugs 100 zu implementieren. Die Überwachungseinheit 230 kann somit Teil des Mikrocontrollers µC sein. Weiterhin ist die Überwachungseinheit 230 ferner ausgebildet, um auch eine Spannung zwischen dem Knotenpunkt 220 und einem Massepotenzial GND, beispielsweise über einen analogen Eingang AD, einzulesen.

Die Zener-Diode D1 hat beispielsweise eine Durchbruchsspannung von 3,7 oder 4,2 V, wenn eine Versorgungsspannung zwischen VCC und GND von 5 V anliegen soll. Die erste Diode D2 und die zweite Diode D3 können beispielsweise Flussspannung von 0,7 V bei einem Einsetzen eines Stromflusses durch diese Dioden aufweisen, so dass durch die Serienschaltung der ersten und zweiten Diode ein Stromfluss erst ab einer gemeinsamen Flussspannung von 1,4 V zu fließen beginnt.

Die Überspannungsschutzschaltung 20 gemäß dem in Fig. 2 dargestellten Ausführungsbeispiel besteht daher aus mindestens zwei in Reihe geschalteten Dioden und einem durch die Überwachungseinheit 230 im Mikrocontroller µC schaltbaren Widerstand R1, der gemäß dem Schaltungsdiagramm aus Fig. 2 einen Wert von 1kΩ aufweist, sowie einer analogen Rückmeldung durch die Möglichkeit des Spannungsabgriffs am Knotenpunkt 220. Wird der Widerstand R1, welcher sich zwischen dem Knotenpunkt 220 der zwei Dioden D1 und D2, des schaltbaren Widerstands R1 und dem Analogeingang AD des µC (d.h. der Überwachungseinheit 230) einerseits und dem Steueranschluss DIO andererseits liegt, am Steuereingang DIO auf High (d.h. auf den Pegel des Versorgungspotentials VCC) gesetzt, so kann die Diode D2 bzw. die beiden Dioden D2 und D3, welche an GND liegt/liegen, mittels Analogrückmeldung über den AD-Eingang (d.h. einem Einlesen einer Spannung zwischen dem Knotenpunkt 220 und dem Massepotenzial GND geprüft werden. In diesem Fall sollte die Spannung am Knotenpunkt 220 durch die Flussspannungen der Dioden D2 und D3 auf 1,4 Volt abfallen, so dass bei einem von diesem erwarteten Wert für die Spannung am Knotenpunkt 220 abweichenden Wert ein Fehler in der Diode D2 oder einer der Dioden D2 oder D3 erkannt werden kann. Die verbleibende Spannung bis zum Versorgungspotenzial VCC fällt in diesem Fall über den Widerstand R1 ab.

Ebenso kann die Zener-Diode D1, welche an dem mit dem Versorgungspotenzial VCC beaufschlagbaren Abgriffspunkt 200 anliegt, durch Schalten des Widerstands R1 an GND geprüft werden. Beispielsweise kann durch ein Setzen des Potenzials des Steueranschlusses DIO auf den Wert des Massepotenzials GND ein Durchschalten der Zener-Diode D1 überprüft werden. Es sollte in diesem Prüffall die Spannung am Knotenpunkt 220 auf einen Wert absinken der der Differenz zwischen der Spannung zwischen dem Versorgungspotenzial VCC und dem Massepotenzial GND einerseits und der Durchbruchsspannung der Zener-Diode D1 andererseits entspricht. Die verbleibende Spannung bis zum Massepotenzial fällt in diesem Fall über den Widerstand R1 ab. Weicht der am Knotenpunkt 220 erfasste Spannungswert im vorstehend genannten Prüffall des Beaufschlagens des Steueranschlusses mit dem Massepotential GND von dem genannten erwarteten Spannungswert ab, kann ebenfalls wieder auf einen Fehler, in diesem Fall in der Zener-Diode D1, geschlossen werden.

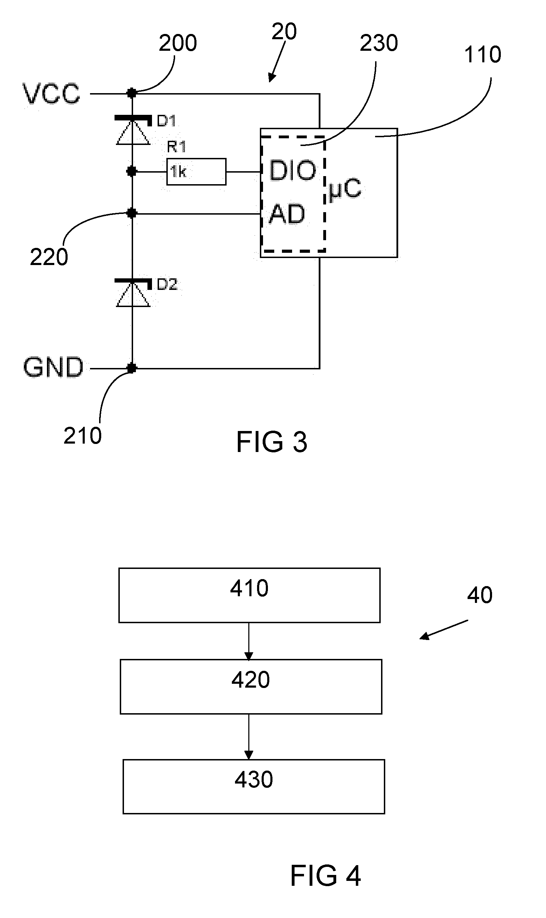

Fig. 3 zeigt ein Schaltungsdiagramm eines zweiten Ausführungsbeispiels der vorliegenden Erfindung einer Überspannungsschutzschaltung. Die Schaltungstopologie der Überspannungsschutzschaltung 20 entspricht dabei der Schaltungstopologie aus Fig. 2 der Uberspannungsschutzschaltung 20 mit dem Unterschied, dass statt der ersten Diode D2 und/oder der zweiten Diode D3 als zweitem Bauelement als zweites Bauelement eine weitere Zener-Diode D2 verwendet wird. Diese weitere Zener-Diode D2 ist dabei derart gepolt, dass ihre Anode mit dem mit dem Massepotenzial GND beaufschlagbaren Abgriffspunkt 210 und ihre Kathode mit dem mit dem Knotenpunkt 220 verbunden ist. Ein derartiges Ausführungsbeispiel der vorliegenden Erfindung bietet gegenüber der in Fig. 2 dargestellten Schaltungstopologie den Vorteil, dass lediglich ein Bauelement verwendet werden braucht, und zugleich eine ausreichend hohe Durchbruchsspannung erreicht werden kann, die zu einer am Knotenpunkt 220 ausreichend hohen abgreifbaren Spannung führt, so dass eine zuverlässige Erkennung von Fehlern im ersten und/oder zweiten elektronischen Bauelement möglich ist.

Alternativ ist es auch möglich, das erste elektronische Bauelement in Form der Zener-Diode D1 durch eine Serienschaltung von zwei Dioden zu setzen, wobei diese entsprechend der Polung aus Fig. 2 zu verschalten wären, das heißt entgegen der Polung der Zener-Diode D1 aus den Figuren 2 und 3.

Fig. 4 zeigt ein Ablaufdiagramm eines Ausführungsbeispiels der vorliegenden Erfindung als Verfahren 40 zur Überprüfung einer Überspannungsschutzschaltung 20. Das Verfahren nutzt eine Überspannungsschutzschaltung, wie sie vorstehend beschrieben wurde. Das Verfahren 40 umfasst einen Schritt des Beaufschlagens 410 des Steueranschlusses mit einer vorbestimmten Spannung oder des Einprägens eines vorbestimmten Stroms in den Steueranschluss. Ferner umfasst das Verfahren einen Schritt des Erfassens 420 einer Spannung am Knotenpunkt und einen Schritt des Erkennens 430 einer Fehlfunktion der Überspannungsschutzschaltung, wenn die erfasste Spannung zwischen dem Knotenpunkt und dem Massepotenzial nicht in einer vorbestimmten Beziehung zu einer erwarteten Spannung am Knotenpunkt steht.

Der Hintergrund der vorliegenden Erfindung liegt somit darin, dass beispielsweise ein Überspannungsschutz mittels einer Z-Diode während der Lebensdauer von Steuergeräte nicht auf Fehlerfreiheit geprüft werden kann. Ein wichtiger Aspekt der vorliegenden Erfindung bestand somit darin, die Nicht-Überwachbarkeit des Überspannungsschutzes zu beheben, wodurch die Steuergeräte mit einem solchen nicht-überprüfbaren Überspannungsschutz eigentlich nicht zur Erhöhung der Sicherheitsanforderungen in einem Nutzfahrzeug herangezogen werden können.

Gemäß der hier vorgeschlagenen Lösung kann die Überspannungsschutzschaltung nun Teil einer internen Rechnerversorgungsspannungs-Einheit sein. Die konstruktive Ausführung der Überspannungsschutzschaltung besteht aus Standardbauteilen. Durch den hier vorgeschlagenen Ansatz kann der Überspannungsschutz während des Betriebs auf Vorhandensein bzw. Wirksamkeit hin überprüft werden. Zugleich sind für die Implementierung des hier vorgestellten Ansatzes lediglich geringe Hardwarekosten zu berücksichtigen.

Die beschriebenen Ausführungsbeispiele sind nur beispielhaft gewählt und können miteinander kombiniert werden.

### Bezugszeichenliste

- 100: Nutzfahrzeug
- 110: Steuergerät
- 120: Bremseinheit
- 130: Energiespeicher, Batterie

- 20: Überspannungsschutzschaltung
- 200: mit dem Versorgungspotenzial beaufschlagbarer Abgriffspunkt
- 210: mit dem Massepotenzial beaufschlagbarer Abgriffspunkt
- 220: Knotenpunkt
- 230: Überwachungseinheit

- D1: Zener-Diode
- D2: erste Diode, Zener-Diode
- D3: zweite Diode
- R1: Widerstand
- DIO: Steueranschluss
- AD: analoger Eingang

- 40: Verfahren zur Überwachung einer Überspannungsschutzschaltung
- 410: Schritt des Beaufschlagens
- 420: Schritt des Erfassens
- 430: Schritt des Erkennens

## Patentansprüche

1. Überspannungsschutzschaltung (20) mit folgenden Merkmalen:
- zumindest einem ersten elektronischen Bauelement (D1) mit einer nichtlinearen Kennlinie, das elektrisch leitfähig zwischen einen mit einem Versorgungspotential (VCC) beaufschlagbaren Abgriffspunkt (200) und einem Knotenpunkt (220) geschaltet ist;
- zumindest einem zweiten elektronischen Bauelement (D2, D3) mit einer nichtlinearen Kennlinie, das elektrisch leitfähig zwischen einen mit einem Massepotenzial (GND) beaufschlagbaren Abgriffspunkt (210) und dem Knotenpunkt (220) geschaltet ist;
- einem Widerstand (R1), der zwischen dem Knotenpunkt (220) und einem Steueranschluss (DIO) geschaltet ist; und
- einer Überwachungseinheit (230), die ausgebildet ist, um an dem Steueranschluss (DIO) eine vorbestimmte Spannung anzulegen oder über den Steueranschluss (DIO) einen vorbestimmten Strom auszugeben und hierauf ansprechend eine Spannung oder ein Potenzial an dem Knotenpunkt (220) zu erfassen, wobei die Überwachungseinheit (230) ausgebildet ist, um eine Fehlfunktion der Überspannungsschutzschaltung (20) zu erkennen, wenn die erfasste Spannung oder das erfasste Potenzial nicht in einer vorbestimmten Beziehung zu einer erwarteten Spannung oder einem erwarteten Potenzial steht.

2. Überspannungsschutzschaltung (20) gemäß Anspruch 1, **dadurch gekennzeichnet, dass** das erste elektronische Bauelement (D1) eine Diode ist, insbesondere deren Kathode mit dem mit dem Versorgungspotential (VCC) beaufschlagbaren Abgriffspunkt (200) und deren Anode mit dem Knotenpunkt (220) verbunden ist.

3. Überspannungsschutzschaltung (20) gemäß Anspruch 2, **dadurch gekennzeichnet, dass** die Diode (D1) eine Zener-Diode ist.

4. Überspannungsschutzschaltung (20) gemäß einem der vorangegangenen Ansprüche, **dadurch gekennzeichnet, dass** das zweite elektronische Bauelement (D2, D3) eine Diode ist.

5. Überspannungsschutzschaltung (20) gemäß Anspruch 4, **dadurch gekennzeichnet, dass** das zweite elektronische Bauelement (D2) eine Diode ist, deren Anode mit dem Knotenpunkt (220) und deren Kathode mit dem mit dem Massepotenzial (GND) beaufschlagbaren Abgriffspunkt (210) verbunden ist.

6. Überspannungsschutzschaltung (20) gemäß Anspruch 5, **dadurch gekennzeichnet, dass** ferner zumindest ein drittes elektronisches Bauelement (D3) mit einer nichtlinearen Kennlinie vorgesehen ist, wobei das dritte elektronische Bauelement (D3) elektrisch leitfähig zwischen das zweite elektronische Bauelement (D2) und den mit dem Massepotenzial (GND) beaufschlagbaren Abgriffspunkt (210) geschaltet ist, insbesondere wobei das dritte elektronische Bauelement (D3) eine Diode ist, deren Anode mit dem zweiten elektronischen Bauelement (D2) und deren Kathode mit dem mit dem Massepotenzial (GND) beaufschlagbaren Abgriffspunkt (210) verbunden ist.

7. Überspannungsschutzschaltung (20) gemäß Anspruch 4, **dadurch gekennzeichnet, dass** das zweite elektronische Bauelement (D2) eine Zener-Diode ist, insbesondere wobei die Kathode der Zener-Diode (D2) mit dem Knotenpunkt (220) und die Anode der Zener-Diode (D2) mit dem mit dem Massepotenzial (GND) beaufschlagbaren Abgriffspunkt (210) verbunden ist.

8. Verfahren (40) zur Überprüfung einer Überspannungsschutzschaltung (20) gemäß einem der vorangegangenen Ansprüche, wobei das Verfahren (40) die folgenden Schritte umfasst:
- Beaufschlagen (410) des Steueranschlusses mit einer vorbestimmten Spannung oder Einprägen eines vorbestimmten Stroms in den Steueranschluss;
- Erfassen (420) einer Spannung oder eines Potenzials an dem Knotenpunkt; und
- Erkennen (430) einer Fehlfunktion der Überspannungsschutzschaltung, wenn die erfasste Spannung oder das erfasste Potenzial nicht in einer vorbestimmten Beziehung zu einer erwarteten Spannung oder einem erwarteten Potential steht.

9. Computer-Programmprodukt mit Programmcode zur Durchführung eines Verfahrens (40) nach Anspruch 8, wenn das Programm auf einem Signalverarbeitungssystem ausgeführt wird.

10. Verwendung einer Überspannungsschutzschaltung (20) gemäß einem der Ansprüche 1 bis 7 und/oder eines Verfahrens (40) gemäß Anspruch 8 in einem Nutzfahrzeug (100), insbesondere zum Einsatz in einem Sicherheitsmittelsteuergerät (110) des Nutzfahrzeugs (100), insbesondere zum Einsatz in einem ABS-Steuergerät.

## Claims

1. Surge protection circuit (20) having the following features:
- at least one first electronic component (D1) having a non-linear characteristic, which first electronic component is electrically conductively connected between a tapping point (200), to which a supply potential (VCC) can be applied, and a node point (220);
- at least one second electronic component (D2, D3) having a non-linear characteristic, which second electronic component is electrically conductively connected between a tapping point (210), to which a ground potential (GND) can be applied, and the node point (220);
- a resistor (R1) which is connected between the node point (220) and a control connection (DIO); and
- a monitoring unit (230) which is designed to apply a predetermined voltage to the control connection (DIO) or to output a predetermined current via the control connection (DIO) and to detect a voltage or a potential at the node point (220) in response to this, wherein the monitoring unit (230) is designed to identify a malfunction in the surge protection circuit (20) when the detected voltage or the detected potential is not related to an expected voltage or an expected potential in a predetermined manner.

2. Surge protection circuit (20) according to Claim 1, **characterized in that** the first electronic component (D1) is a diode, in particular the cathode of said diode being connected to the tapping point (200) to which the supply potential (VCC) can be applied, and the anode of said diode being connected to the node point (220).

3. Surge protection circuit (20) according to Claim 2, **characterized in that** the diode (D1) is a zener diode.

4. Surge protection circuit (20) according to one of the preceding claims, **characterized in that** the second electronic component (D2, D3) is a diode.

5. Surge protection circuit (20) according to Claim 4, **characterized in that** the second electronic component (D2) is a diode, the anode of said diode being connected to the node point (220), and the cathode of said diode being connected to the tapping point (210) to which the ground potential (GND) can be applied.

6. Surge protection circuit (20) according to Claim 5, **characterized in that** at least a third electronic component (D3) having a non-linear characteristic is also provided, wherein the third electronic component (D3) is electrically conductively connected between the second electronic component (D2) and the tapping point (210) to which the ground potential (GND) can be applied, in particular wherein the third electronic component (D3) is a diode, the anode of said diode being connected to the second electronic component (D2), and the cathode of said diode being connected to the tapping point (210) to which the ground potential (GND) can be applied.

7. Surge protection circuit (20) according to Claim 4, **characterized in that** the second electronic component (D2) is a zener diode, in particular wherein the cathode of the zener diode (D2) is connected to the node point (220), and the anode of the zener diode (D2) is connected to the tapping point (210) to which the ground potential (GND) can be applied.

8. Method (40) for testing a surge protection circuit (20) according to one of the preceding claims, wherein the method (40) comprises the following steps:
- applying (410) a predetermined voltage to the control connection or impressing a predetermined current into the control connection;
- detecting (420) a voltage or a potential at the node point; and
- identifying (430) a malfunction in the surge protection circuit when the detected voltage or the detected potential is not related to an expected voltage or an expected potential in a predetermined manner.

9. Computer program product having program code for carrying out a method (40) according to Claim 8 when the program is executed on a signal-processing system.

10. Use of a surge protection circuit (20) according to one of Claims 1 to 7 and/or of a method (40) according to Claim 8 in a utility vehicle (100), in particular for use in a safety means controller (110) of the utility vehicle (100), in particular for use in an ABS controller.

## Revendications

1. Circuit de protection contre les surtensions (20) présentant les caractéristiques suivantes :
- au moins un premier composant électronique (D1) à une courbe caractéristique non-linéaire, qui est couplé de façon électriquement conductive entre un point de prise (200), auquel on peut appliquer un potentiel d'alimentation (VCC), et un point de noeud (220) ;
- au moins un deuxième composant électronique (D2, D3) à une courbe caractéristique non-linéaire, qui est couplé de façon électriquement conductive entre un point de prise (210), auquel on peut appliquer un potentiel de mise à la terre (GND), et un point de noeud (220) ;
- une résistance (R1) couplée entre ledit point de noeud (220) et une borne de commande (DIO) ; et
- une unité de surveillance (230) configurée pour l'application d'une tension prédéterminée à ladite borne de commande (DIO) ou pour la sortie d'un courant prédéterminé via ladite borne de commande (DIO) et pour la détection, en réponse, d'une tension ou un potentiel audit point de noeud (220), cette unité de surveillance (230) étant configurée pour la détection d'un dysfonctionnement du circuit de protection contre les surtensions (20), quand la tension détectée ou le potentiel détecté ne se trouve pas en une relation prédéterminée à une tension attendue ou un potentiel attendu.

2. Circuit de protection contre les surtensions (20) selon la revendication 1, **caractérisé en ce que** ledit premier composant électronique (D1) est une diode, en particulier une diode dont la cathode est reliée audit point de prise (200), auquel on peut appliquer un potentiel d'alimentation (VCC), et dont l'anode est reliée audit point de noeud (220).

3. Circuit de protection contre les surtensions (20) selon la revendication 2, **caractérisé en ce que** ladite diode (D1) est une diode Zener.

4. Circuit de protection contre les surtensions (20) selon une quelconque des revendications précédentes, **caractérisé en ce que** ledit deuxième composant électronique (D2, D3) est une diode.

5. Circuit de protection contre les surtensions (20) selon la revendication 4, **caractérisé en ce que** ledit deuxième composant électronique (D2) est une diode, dont l'anode est reliée audit point de noeud (220) et dont la cathode est reliée audit point de prise (210), auquel on peut appliquer le potentiel de mise à la terre (GND).

6. Circuit de protection contre les surtensions (20) selon la revendication 5, **caractérisé en ce qu'**au plus au moins un troisième composant électronique (D3) à une courbure caractéristique non-linéaire est disposé, audit troisième composant électronique (D3) étant couplé de façon électriquement conductive entre ledit deuxième composant électronique (D2) et ledit point de prise (210), auquel on peut appliquer un potentiel de mise à la terre (GND), en particulier audit troisième composant électronique (D2) étant une diode, dont l'anode est reliée audit deuxième composant électronique (D2) et dont la cathode est reliée audit point de prise (210), auquel on peut appliquer ledit potentiel de mise à la terre (GND).

7. Circuit de protection contre les surtensions (20) selon la revendication 4, **caractérisé en ce que** ledit deuxième composant électronique (D2) est une diode Zener, en particulier une diode Zener (D2), dont la cathode est reliée audit point de noeud (220) et dont l'anode est reliée audit point de prise (210), auquel on peut appliquer ledit potentiel de mise à la terre (GND).

8. Procédé (40) de révision d'un circuit de protection contre les surtensions (20) selon une quelconque des revendications précédentes, ce procédé (40) comprenant les étapes suivantes :
- application (410) d'une tension prédéterminée à ladite borne de commande ou application d'un courant prédéterminé dans ladite borne de commande ;
- détection (420) d'une tension ou d'un potentiel audit point de noeud ; et
- détection (430) d'un dysfonctionnement du circuit de protection contre les surtensions, quand la tension détection ou le potentiel détecté ne se trouve pas dans une relation prédéterminée avec une tension attendue ou un potentiel attendu.

9. Produit de programme d'ordinateur à un code de programme pour la réalisation d'un procédé (40) selon la revendication 8, quand le programme est exécuté sur un système de traitement de signaux.

10. Utilisation d'un circuit de protection contre les surtensions (20) selon une quelconque des revendications 1 à 7 et/ou d'un procédé (40) selon la revendication 8 dans un véhicule utilitaire (100), en particulier pour l'emploi dans un dispositif de commande de support de sécurité (110) dudit véhicule utilitaire (100), en particulier pour l'emploi dans une unité de contrôle ABS.
